# EUROPEAN PATENT APPLICATION

(11) **EP 1 519 217 A1**
(43) Date of publication of application: **30.03.2005**
(21) Application number: 04090221.5
(22) Date of filing: 08.06.2004
(51) Int. Cl.: G02F 1/133

(54) **Display apparatus having heat transfer sheet**

(30) Priority: 26.09.2003 KR 2003066993
(71) Applicant: Samsung SDI Co., Ltd., Suwon-si, Gyeonggi-do (KR)
(72) Inventor: Kim, Ki-Jung, Cheonan-si Chungcheongnam-do (KR); Kang, Tae-Kyoung Leg. & IP Team Samsung SDI Co Ltd, Kyeonggi-Do (KR); Cho, In-Soo, Boodang-gu Seongnam-si Gyeonggi-do (KR)
(74) Representative: Hengelhaupt, Jürgen, Dipl.-Ing.

(57) **Abstract**

A display apparatus (10) includes a display panel (12) and a heat transfer sheet (14) mounted adjacent to one surface of the display panel. A plurality of pores (14a) are formed in the heat transfer sheet. The heat transfer sheet may have an open cell-type structure and/or a closed cell-type structure. The open cell-type structure includes pores that are interconnected. The closed cell-type structure includes pores that are not connected with each other.

## Description

### BACKGROUND OF THE INVENTION

### Field of the Invention

The present invention relates to a display apparatus, and more particularly, to a display apparatus including an assembly for efficiently discharging heat generated by a display panel.

### Discussion of the Related Art

As societies become more information-based, the demand for better displays increases. In response to this demand, display devices are becoming increasingly varied in configuration and operation. These display devices may vary, for example, from the displays used in digital wristwatches and calculators, to small and large size television screens and displays having high resolutions. These display devices have different sizes, display capacities, display colors, and other different characteristics, which may depend on their intended use.

There has been a particularly marked increase in the demand for display devices having a thin profile (e.g., flat panel displays) for use in laptop computers, cell phones, and large-screen TVs. Some examples of such flat panel display configurations include liquid crystal displays (LCDs), organic light emitting displays (OLEDs), field emission displays (FEDs), and plasma display devices.

An LCD uses electro-optical characteristics of liquid crystals to vary light transmission amounts according to an applied electric field for displaying images. More specifically, the LCD includes a panel that applies an electric field to liquid crystals in minute area units, a driver that controls the liquid crystals to show desired pictures, and a light supply assembly that generates light that passes through the liquid crystals. Heat is generated in the light supply assembly as a natural consequence of operation. Such heat may affect the panel and controls, thereby reducing the precision of the display.

In an OLED, electrons and holes are injected into an organic illumination layer. More specifically, electrons are injected from a cathode (e.g., an electron injection electrode), and holes are injected from an anode (e.g., the hole injection electrode). The injected electrons and holes are combined to generate excitons, which illuminate when going from an excited state to a ground state. In this type of configuration, only a portion of the injected electric charge illuminates and the rest is lost as heat. The heat negatively affects the organic illumination layer because organic material is more susceptible to heat damage than inorganic material.

The FED utilizes a quantum mechanics tunneling effect to emit electrons from electron emission sources formed on cathode electrodes. The emitted electrons strike a phosphor layer formed on an anode electrode to illuminate the phosphor layer, thereby resulting in a display of images. Heat is also generated in the panel of the FED and if the heat is not efficiently discharged from the FED, the panel is negatively affected.

The plasma display device displays images on a plasma display panel using plasma generated by a gas discharge and the high temperature discharge gas generates heat. Moreover, if the discharge is increased in an attempt to improve brightness, it generates more heat in the display panel. Accordingly, it is necessary to more efficiently dissipate such heat from the plasma display device.

In conventional devices, the plasma display panels are attached to a chassis base made of a highly thermally conductive material. A heat discharge sheet (e.g. a thermal conduction sheet) is arranged between the display panel and the chassis base in order to dissipate heat. In this configuration, the heat discharge sheet and the chassis base expel heat generated by the plasma display. More specifically, the chassis base is typically manufactured through a die-casting or a press using a metal, such as aluminum, and the heat discharge sheet is made of an acryl-, silicon-, or urethane-based resin.

These heat discharge sheets have low thermal conductivities, typically ranging from about 0.8 to about 1.5W/mK. In these conventional systems, heat generated in the panel is transmitted solely by conduction. As a result of this mechanism, it is necessary that the heat discharge sheet closely contacts both the plasma display and the chassis base. It also is necessary to have a high degree of adhesivity between these elements. However, in conventional devices there are typically large areas where gaps of air exist in the contact surfaces between these elements reducing adhesion, reducing the heat discharge efficiency. To measure the degree of adhesivity a transparent glass may be used in place of the panel and a silicon sheet is interposed between the chassis base and the transparent glass. In these conventional systems it has been determined that the adhesivity ranges from about 10% to about 20%.

Various configurations have been disclosed in an attempt to improve the adhesivity that is, the area of adhesion between components and to increase heat discharge efficiency. The following describes one such configuration.

For example, in U.S. Patent No. 5,971,566, a shock-absorbing material is attached around a circumference of a panel and a liquid thermal conduction medium is applied to the region surrounded by the shock-absorbing material. The thermal conduction material is then hardened and the display panel is attached to the solid thermal conduction material, thereby realizing a PDP that promotes heat discharge efficiency. However, this configuration has a disadvantage as it is difficult to obtain a reliable degree of adhesivity with large screen sizes.

Additionally, in Japanese Laid-Open Patent No. Heisei 11-251777, a thermal conduction sheet is arranged between a display panel and a thermal conduction plate (e.g., chassis base). Heat pipes, heat discharge pins, and a heat discharge plate are mounted to a rear surface of the thermal conduction plate. The plasma display device realizes a uniform distribution of heat through this type of configuration, however, this type of structure also has disadvantages as it creates a large profile and generates noise.

Bright image stickings may result when there are differences in the image pattern being displayed as heat is concentrated at specific regions of the display. For example, a bright image sticking may be localized in a region of the display. That is, a portion of the screen stays momentarily brighter than the surrounding area. This effect occurs after a relatively bright image has been displayed in a localized area of the display. For example, a difference in the brightness occurs when continuously displaying a full white pattern (e.g., the entire screen is white) on the display for 20 minutes followed by displaying a 3% window pattern for 10 minutes and then displaying a full white pattern. That is, a difference in brightness occurs at a location between where the 3% window pattern was displayed and its surrounding area. The area of increased brightness is referred to as a bright image sticking. The 3% window pattern refers to a white region in which a load ratio is provided as much as 3%. This bright image sticking is caused by temperature changes affecting phosphor illumination.

Accordingly, there is a need for effective heat discharge. More specifically, there is a need for a heat discharge sheet that provides for greater thermal conductivity to prevent or minimize bright image stickings affecting picture quality. Also, there is a need for a heat discharge sheet that provides greater thermal conductivity in the planar direction than in the direction of display width, so that heat generated by the display may be uniformly dispersed with such a heat discharge sheet.

A plasma display device is disclosed in US Patent No. 5,831,374. This device utilizes a graphite thermal spread sheet for heat distribution. The graphite thermal spread sheet has a greater thermal conductivity in the planar direction of the plasma display than its thermal conductivity in the width direction. As a result, the heat generated in the plasma display is more quickly distributed in the planar direction and bright image stickings are reduced. However, it is difficult to prevent the formation of an air layer because graphite is hard and easily cracks. This air layer reduces the actual area of attachment to the plasma panel, thereby minimizing heat discharge efficiency. Also, the graphite thermal spread sheet is limited in its ability to alleviate external vibrations and shocks. More specifically, the graphite thermal spread sheet directly transmits panel noise to the chassis base (e.g., without first reducing the noise) where the transferred noise is amplified.

### SUMMARY OF THE INVENTION

The invention is directed towards a display apparatus, and more particularly, to a display apparatus including an assembly for efficiently discharging heat generated by a display panel. A heat transfer sheet including a plurality of pores provides an effective heat transfer mechanism. The plurality of pores in the heat transfer sheet may include a open and/or closed type cell structures. Additionally, the heat transfer sheet may include a plurality of fibrous elements and/or flakes. The heat transfer sheet may be formed from any of the following materials or combination of materials aluminum, copper, silver, gold, steel, nickel, stainless, steel, brass, carbon, graphite, carbon nanotubes, carbon fiber, and the like. Optionally, a thin metal plate or film may also be utilized in the apparatus.

The heat transfer sheet may be used in any number of display devices. For example, the heat transfer sheet may be used in LCDs, OLEDs, FEDs, and plasma display devices.

One exemplary embodiment of the present invention discloses a display apparatus in which a heat transfer sheet include a plurality of pores and is attached to a display panel in a display apparatus such that an actual contact area with the display panel is increased and heat generated by the same is quickly transferred and dispersed.

Another exemplary embodiment of the present invention discloses a display apparatus in which a heat transfer sheet includes a plurality of pores is attached to a display panel such that external vibrations and shocks are reduced.

Yet another exemplary embodiment of the present invention discloses a display apparatus in which a heat transfer sheet includes a plurality of pores and is attached to a display panel such that discharge noise generated by the display panel is dissipated in the pores to reduce overall noise generation of the display apparatus.

In still yet another exemplary embodiment of the present invention, there is provided a display apparatus in which electromagnetic waves generated during discharge are absorbed in a display panel and grounded through a chassis base to prevent transmission of the EM waves to a circuit.

In an exemplary embodiment of the present invention, a display apparatus includes a display panel and a heat transfer sheet mounted adjacent to a surface of the display panel. The heat transfer sheet includes plurality of pores.

The heat transfer sheet includes a plurality of pores. The plurality of pores have either an open cell-type structure in which the pores are interconnected or a closed cell-type structure in which the pores are not in communication with each other. That is, in the closed cell-type structure the pores are formed independently.

The plurality of pores arranged in the heat transfer sheet may formed to range from about 5 to about 80 pores per inch (ppi). Additionally, the heat transfer sheet may have a porosity ranging from about 35% to about 95%.

The porous heat transfer sheet may be made of a metal material. For example, the heat transfer sheet may comprise aluminum, copper, silver, gold, steel, nickel, stainless steel, brass, and the like.

The heat transfer sheet may have a greater thermal conductivity in a planar direction than the thermal conductivity in a direction of a width of the heat transfer sheet. For example, the thermal conductivity in substantially a x-y planar direction of the heat transfer sheet may be five times or more the thermal conductivity in the z direction of the porous heat transfer sheet. In this case, the porous heat transfer sheet may be made of carbon, graphite, carbon nanotubes, carbon fiber, and the like.

A thin film layer may be formed on a surface of the display panel opposing the porous heat transfer sheet. The thin film layer may have thermal conductivity that is higher than that of the display panel. The thin film layer may be made of ceramic or teflon.

A thin metal plate may be arranged between the display panel and the porous heat transfer sheet. The thin metal plate may be made of one of aluminum and/or copper.

The display panel may be a flat panel display, for example, a plasma display panel, a liquid crystal display, an organic light emitting display, or a field emission display.

In another exemplary embodiment according to the present invention, a plurality of fibrous elements are bound to the heat transfer sheet to realize a porous assembly. In still yet another exemplary embodiment according to the present invention, a plurality of flakes are arranged together in the heat transfer sheet to realize a porous assembly.

The fibrous elements or the flakes may be made of a metal material. Also, the fibrous elements or the flakes may be made of a material having anisotropic thermal conductivity, such as, for example, carbon, graphite, carbon nanotubes, carbon fiber, and the like.

A thin film layer may be coated on a surface of the display panel opposing the porous heat transfer sheet. The thin film layer has thermal conductivity that is higher than that of the display panel.

Further, a thin metal plate may be interposed between the display panel and the porous heat transfer sheet.

In the case where it is applied to a plasma display device, the heat transfer sheet is interposed between the plasma display panel and the chassis base, which are provided substantially in parallel.

A depression may be formed on a side of the chassis base opposing the plasma display panel, in this configuration the porous heat transfer sheet is arranged within the depression of the chassis base and interposed between the chassis base and the plasma display panel.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

FIG. 1 shows a partial exploded perspective view of a plasma display device according to an exemplary embodiment of the present invention.

FIG. 2 shows a partial side sectional view and a partial exploded view of a plasma display device in an assembled state according to an exemplary embodiment of the present invention.

FIG. 3 shows an internal photograph of a heat transfer sheet including aluminum having a plurality of pores according to an exemplary embodiment of the present invention.

FIG. 4 shows an internal photograph of a heat transfer sheet including graphite having a plurality of pores according to an exemplary embodiment of the present invention.

FIG. 5 shows a schematic view used to illustrate the generation of a bright image sticking.

FIG. 6 shows a partial side sectional view of a plasma display device according to another exemplary embodiment of the present invention.

FIG. 7 shows a partial side sectional view of a plasma display device according to another exemplary embodiment of the present invention.

FIG. 8 shows a partial side sectional view of a plasma display device according to another exemplary embodiment of the present invention.

FIG. 9 shows a partial side sectional view of a plasma display device according to another exemplary embodiment of the present invention.

FIG. 10 shows a partial side sectional view of a plasma display device according to another exemplary embodiment of the present invention.

FIG. I 1 shows a schematic view showing a liquid crystal display device having a heat transfer sheet including a plurality of pores according to a further exemplary embodiment of the present invention.

FIG. 12 shows a schematic view of an organic light emitting display device including a heat transfer sheet including a plurality of pores according to another exemplary embodiment of the present invention.

FIG. 13 shows a schematic view of a field emission display device having a heat transfer sheet including a plurality of pores according to another exemplary embodiment of the present invention.

### DETAILED DESCRIPTION OF THE ILLUSTRATED EMBODIMENTS

Reference will now be made in detail to embodiments of the present invention, examples of which may be illustrated in the accompanying drawings.

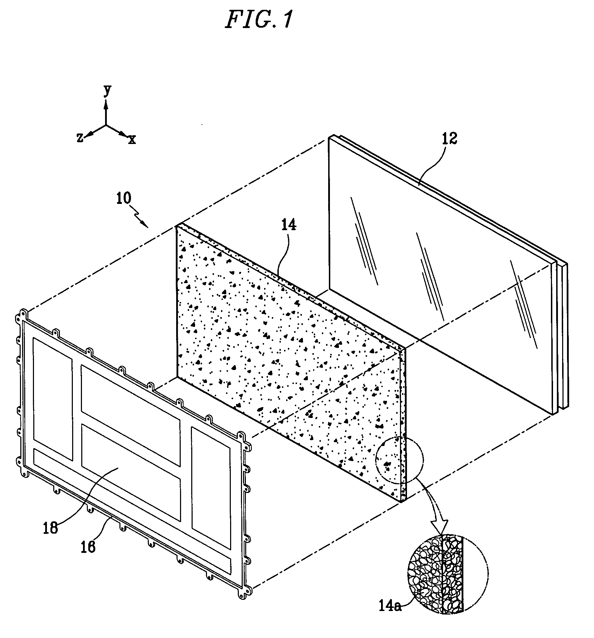

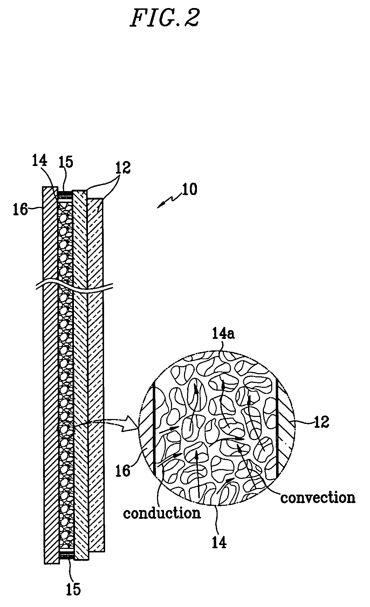

FIG. 1 shows a partial exploded perspective view of a plasma display device according to an exemplary embodiment of the present invention. FIG. 2 shows a partial side sectional view and a partial exploded view of a plasma display device in an assembled state according to an exemplary embodiment of the present invention.

Referring to FIGs. 1 and 2, a plasma display device 10 includes a display panel 12 and a chassis base 16. The display panel 12 and the chassis base 16 each have a predetermined thickness and may have a substantially rectangular configuration. The chassis base 16 and display panel 12 each have two opposing surfaces encompassed by sides. The display panel 12 may be mounted to the chassis base 16 with one of its faces being substantially adjacent to a face of the chassis base 16. Circuit elements 19 for driving the display panel 12 may be mounted facing the chassis base 16 opposite the face adjacent to the display panel 12.

In one configuration, the chassis base 16 may be arranged substantial parallel to the display panel 12. More specifically, a heat transfer sheet 14 may be interposed between the chassis base 16 and the display panel 12. The heat transfer sheet 14 may be arranged to closely contact the chassis base 16 and the display panel 12 in order to expel and disperse heat generated by the display panel. Two-sided tape 15 may be attached around outer edges of the heat transfer sheet 14 between the display panel 12 and the chassis base 16, thereby securing the heat transfer sheet 14 and putting the display panel 12 together with the chassis base 16.

Additionally, a front cover (not shown) may be positioned to cover exposed surfaces of the display panel 12. That is, after the display panel 12 is arranged with the chassis base 16 and a rear cover (not shown) is positioned to cover exposed surfaces of the chassis base 16, the front cover and the rear cover are interconnected to complete the plasma display device 10. Alternatively, the heat transfer sheet 14 may be adhered directly to the display panel 12 and the chassis base 16 by applying an adhesive. For example, a silicon-based or acryl-based adhesive may be applied on a surface of the heat transfer sheet 14 and then the display panel 12 and the chassis base 16 are put together.

The heat transfer sheet 14 is made of a porous material, for example, a material having a plurality of pores 14 formed throughout its structure. The porous heat transfer sheet 14 may have an open cell-type structure or a closed cell-type structure. In the open cell-type structure at least a portion of the pores 14a in the heat transfer sheet 14 are interconnected. In the closed cell-type structure at least a portion of the pores are not interconnected.

When utilizing the above configuration, the heat transfer sheet 14 is attached to the surfaces of the display panel 12 and the chassis base 16. Air present between the heat transfer sheet 14 and the display panel 12 and the chassis base 16 escapes through the pores 14a. As a result, adhesion between these elements is significantly increased. That is, when using a conventional silicon thermal conduction sheet or a graphite thermal spread sheet, the contact surface area ranges from about 10% to about 20% between the display panel 12 and heat transfer sheet 14. This contact surface area is increased to approximately a 50% or greater when using the porous heat transfer sheet 14 according to the exemplary embodiment of the present invention. Accordingly, the adhesion between these elements is significantly increased.

Additionally, the heat transfer sheet 14 has shock-absorbing properties due to the plurality of pores 14a. Accordingly, the heat transfer sheet 14 reduces external vibrations and shocks, thereby protecting the display panel 12. Moreover, discharge noise generated by the display panel 12 may be converted to heat energy in the pores 14a, thereby reducing the overall noise of the plasma display device.

As shown in FIG. 2, the structure of the porous heat transfer sheet 14 has a large contact surface with air. Also, air passes easily through the porous heat transfer sheet 14 of the open cell-type structure because the pores 14a are interconnected. Accordingly, heat generated by the display panel 12 is either dispersed to peripheries or expelled outside the device by conduction and/or convection, thereby improving heat discharge efficiency.

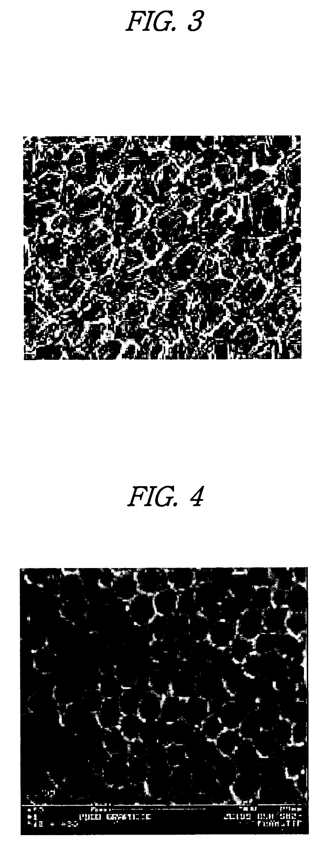

The porous heat transfer sheet 14 may be made of metal. For example, the heat transfer sheet 14 may comprise aluminum, copper, silver, gold, steel, nickel, stainless steel, brass, and the like. FIG. 3 is a photograph of an internal structure of the heat transfer sheet 14 made of aluminum. As is evident from the picture, the pores are substantially interconnected to one another.

Further, the porous heat transfer sheet 14 may be made of a material having anisotropic thermal conductivity. Some examples of the materials may include carbon, graphite, carbon nanotubes, carbon fiber, and the like. The porous heat transfer sheet 14 made of one of these materials has a greater thermal conductivity in a planar direction than in a direction of the width of the heat transfer sheet 14. For example, the thermal conductivity in substantially the x-y planar direction is at least five times greater than the thermal conductivity in the z direction of the heat transfer sheet 14. That is, the thermal conductivity in the x-y plane is at least about five times greater than the thermal conductivity in z plane of the heat transfer sheet.

FIG. 4 shows a photograph of an internal structure of a heat transfer sheet made of graphite having a plurality of pores according to an exemplary embodiment of the present invention.

Referring to FIG. 4, the pores in the heat transfer sheet 14 are closed cell-type structure where at least a portion of the pores are not interconnected. Additionally, the number of pores in the heat transfer sheet 14 may be in a range of about 5 to about 80 pores per inch (ppi). The pores 14a may be sized to fall within this range. If the range falls below 5 ppi, the bright image sticking cannot be easily removed. Additionally, if the range goes over 80 ppi, it becomes difficult to remove air between the heat transfer sheet 14 and the elements contacting the same.

The pores 14a may be formed such that the porosity (η) of the heat transfer sheet 14 varies from between about 35% to about 95%. The porosity (η) is obtained by setting Vs to equal a volume of solid areas of the porous heat transfer sheet 14 and V to equal a volume occupied by all the pores 14a, after which these values are applied to the equation (η) = (V-Vs)/V * 100%.

If the porosity (η) of the porous heat transfer sheet 14 is less than about 35%, the shock-absorbing capability is decreased and it becomes difficult to remove the air gap between the display panel 12 and the porous heat transfer sheet 14 reducing the adhesivity between these elements. On the other hand, if the porosity (η) of the porous heat transfer sheet 14 is greater than about 95%, contact area between the display panel 12 and the porous heat transfer sheet 14 is reduced, making it difficult to remove bright image stickings as the thermal conductivity is reduced.

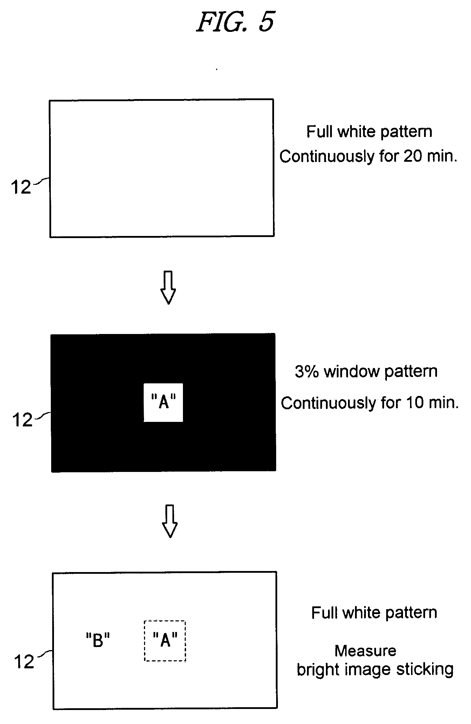

FIG. 5 shows a schematic view showing the generation of a bright image sticking as a result of the concentration of heat at a localized area.

Referring to FIG. 5, illustrating a full white pattern on the screen of a display panel 12 which may be continuously displayed for 20 minutes. Next, a 3% window pattern (indicated by "A") is displayed for 10 minutes, and this is followed by displaying a full white pattern. The degree of bright image sticking generation may be measured by how long it takes for the brightness difference between the 3% window pattern "A" and its surrounding area B to become 7 cd/m² or less. When using a conventional silicon sheet the bright image sticking display time is approximately 180 seconds. This time is reduced to about 90 to about 100 seconds when utilizing the heat transfer sheet 14 of the present invention.

Additional exemplary embodiments of the present invention will now be described. When structural elements are identical to those described with reference to the above exemplary embodiment, the same reference numerals will be used.

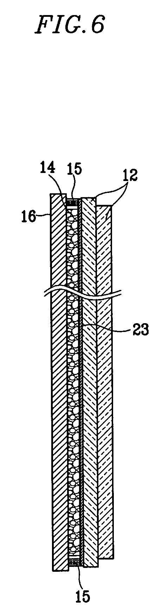

FIG. 6 shows a partial side sectional view of a plasma display device according to another exemplary embodiment of the present invention.

Referring to FIG. 6, the porous heat transfer sheet 14 may be arranged between the chassis base 16 and the display panel 12. A thin film layer 23 is formed on the surface of the display panel 12 opposing the porous heat transfer sheet 14. The thin film layer 23 is selected from a material having a thermal conductivity greater than the display panel 12.

For example, ceramic or teflon may be used to form the thin film layer 23. The thickness of the thin film layer 23 may vary from about 10 µm to about 50 µm. Resistance to wear, thermal conductivity, and insulation properties of the display panel 12 are improved by forming the thin film layer 23 on the surface of the display panel 12 opposing the porous heat transfer sheet 14. Additionally, the thin film layer 23 may be coated with a material mixed with black pigment, to minimize reflection and improve contrast of the display.

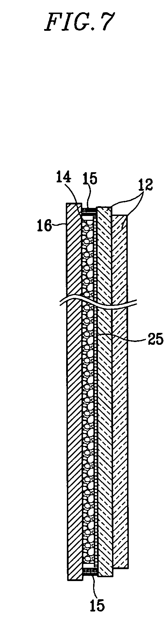

FIG. 7 shows a partial side sectional view of a plasma display device according to yet another exemplary embodiment of the present invention.

Referring to FIG. 7, the porous heat transfer sheet 14 is arranged between the chassis base 16 and the display panel 12. In this embodiment, a thin metal plate 25 may be arranged between the display panel 12 and the porous heat transfer sheet 14. The thin metal plate 25 may be made of metal, for example, aluminum and/or copper. Scratching of the display panel 12 surface is prevented during assembly of the porous heat transfer sheet 14 and the display panel 12 by orienting the thin metal plate 25 between the chassis base 16 and the display panel 12. Moreover, heat generated by the display panel 12 is more easily transmitted to the porous heat transfer sheet 14.

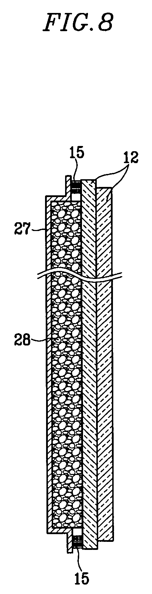

FIG. 8 shows a partial side sectional view of a plasma display device according to still yet another exemplary embodiment of the present invention.

Referring to FIG. 8, a depression may be formed on a side of a chassis base 27. A porous heat transfer sheet 28 is arranged within the depression of the chassis base 27, thereby being arranged between the chassis base 27 and the display panel 12. Utilizing this configuration, the chassis base 27 can encompass outer edges of the porous heat transfer sheet 28, thereby supporting and reinforcing the heat transfer sheet 28.

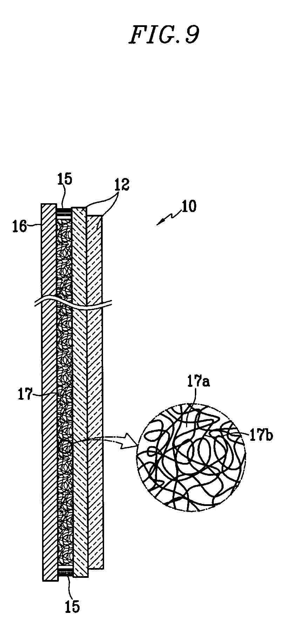

FIG. 9 shows a partial side sectional view of a plasma display device according to still yet another exemplary embodiment of the present invention.

Referring to FIG. 9, a heat transfer sheet 17 may be formed by binding a plurality of fibrous elements 17b to form a porous assembly. In this embodiment, the heat transfer sheet 17 is arranged between the PDP 12 and the chassis base 16. Two-sided tape 15 is attached around outer edges of the heat transfer sheet 17 between the PDP 12 and the chassis base 16 to secure the heat transfer sheet 17. Additionally, an adhesive may be applied to surfaces of the heat transfer sheet 17 contacting the PDP 12 and the chassis base 16 to directly adhere the heat transfer sheet 17 to PDP 12 and chassis base 16.

The heat transfer sheet 17 includes pores 17a that are formed between the fibrous elements 17b. The area of adhesion is increased when utilizing a heat transfer sheet 17 formed in this manner. Additionally, similar advantages described with reference to the porous heat transfer sheet 14 of FIG. 2 are also realized. For example, it improves shock-absorbing and noise reduction properties and enhances heat discharge efficiency.

The fibrous elements 17b forming the heat transfer sheet 17 may be made of metal. For example, the fibrous elements 17b may be made of metals that are highly conductive such as aluminum, copper, silver, gold, steel, nickel, stainless steel, brass, and the like.

In addition, the fibrous elements 17b may be made of a material having anisotropic thermal conductivity. For example, some of these materials include carbon, graphite, carbon nanotubes, carbon fiber, and the like. Preferably, the heat transfer sheet 17 made of one of these materials has thermal conductivity in a planar direction that is greater than in a direction of the width of the heat transfer sheet 17. The bright image stickings are minimized as the thermal conductivity in substantially the x-y planar direction is at least five times higher than the thermal conductivity in the z direction of the heat transfer sheet 17.

As illustrated in the embodiment of FIG. 6, a thin film layer may be formed on the surface of the display panel 12 opposing the heat transfer sheet 17. The thin film layer is selected from a material having a higher thermal conductivity than the display panel 12. Additionally, a thin metal plate may be interposed between the display panel 12 and the heat transfer sheet 17 as illustrated in the exemplary embodiment of FIG. 7. Also, as in the exemplary embodiment of FIG. 8, a depression may be formed on a side of the chassis base 16 opposing the display panel 12. In this configuration the heat transfer sheet 17 may be mounted within the depression of the chassis base 16 to be interposed between this element and the display panel 12.

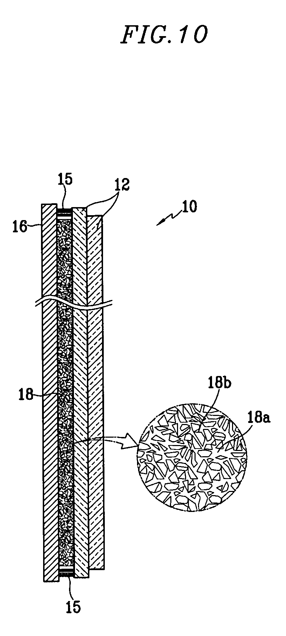

FIG. 10 is a partial side sectional view of a plasma display device according to still yet another exemplary embodiment of the present invention.

Referring to FIG. 10, a heat transfer sheet 18 is formed by arranging together a plurality of flakes 18b, thereby forming a porous assembly. This heat transfer sheet 18 is arranged between the display panel 12 and the chassis base 16. Two-sided tape 15 is attached around outer edges of the heat transfer sheet 18 between the display panel 12 and the chassis base 16 to secure the heat transfer sheet 18. An adhesive may be applied to surfaces of the heat transfer sheet 18 contacting the display panel 12 and the chassis base 16 so that the heat transfer sheet 18 is adhered to these elements.

In the heat transfer sheet 18, pores 18a are formed between the flakes 18b. A heat transfer sheet 18 formed in this manner realizes the similar advantages as described above with reference to the porous heat transfer sheet 14 of FIG. 2. Additionally, the adhesion area between the heat transfer sheet 18 and the display panel 12 of the chassis base 16 is increased. Moreover, it improves shock-absorbing and noise reduction properties and enhances heat discharge efficiency.

The flakes 18b forming the heat transfer sheet 18 may be made of a metal material. For example, the flakes 18b may be formed of metals that are highly conductive such as aluminum, copper, silver, gold, steel, nickel, stainless steel, brass, and the like.

In addition, the flakes 18b may be made of a material having anisotropic thermal conductivity. Some examples of these materials include carbon, graphite, carbon nanotubes, and carbon fiber. For example, the heat transfer sheet 18 may be made with one of these materials that has a greater thermal conductivity in a planar direction than the thermal conductivity in a direction of the width of the heat transfer sheet 18. In order to minimize bright image stickings, the thermal conductivity in substantially the x-y planar direction is at least five times greater than the thermal conductivity in the z direction of the width of the heat transfer sheet 18.

In this exemplary embodiment, as with the exemplary embodiment of FIG. 6, a thin film layer may be formed on the surface of the display panel 12 opposing the heat transfer sheet 18, with the thin film layer having thermal conductivity that is higher than that of the display panel 12. Also, a thin metal plate may be interposed between the display panel 12 and the heat transfer sheet 18 as in the exemplary embodiment of FIG. 7. Finally, as in the exemplary embodiment of FIG. 8, a depression may be formed on a side of the chassis base 16 opposing the display panel 12, and the heat transfer sheet 18 may be mounted within the depression of the chassis base 16 to be interposed between this element and the display panel 12.

In the exemplary embodiments described above, porous heat transfer sheets are utilized in plasma display devices. In addition to plasma display devices, the porous heat transfer sheets of the present invention may be applied to LCDs, OLEDs, FEDs, and other display configurations. Some examples of these alternate applications are described below.

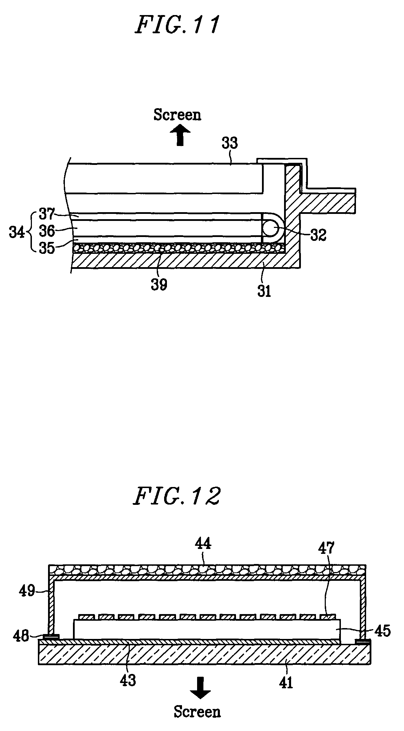

FIG. 11 shows a schematic view showing a liquid crystal display device having a heat transfer sheet including a plurality of pores according to a further exemplary embodiment of the present invention.

Referring to FIG. 11, the LCD includes a liquid crystal panel assembly 33 and a backlight assembly 34 received in a case 31. The case 31 is designed with enough space for this purpose. The liquid crystal panel assembly 33 includes a liquid crystal panel and a control module and acts to precisely control an alignment angle of liquid crystals injected between two electrodes, thereby varying (e.g., in minute area units) the amount of light that can pass through the liquid crystals. The backlight assembly 34 includes an optical sheet 37, a light guide plate 36, and a reflection plate 35. Also, the backlight assembly 34 supplies light that passes through the liquid crystals that are aligned to vary light transmission amounts.

In the LCD structured as broadly described above, a porous heat transfer sheet 39 may be mounted adjacent to a rear surface of the backlight assembly 34. Accordingly, the heat generated by the backlight assembly 34 is transmitted to the case 31 and realizes an efficient heat discharge.

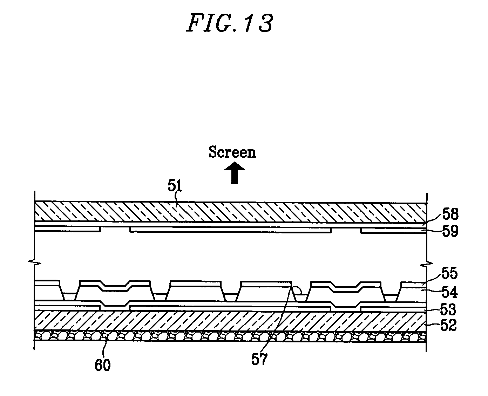

FIG. 12 shows a schematic view of an organic light emitting display including a heat transfer sheet including a plurality of pores according to another exemplary embodiment of the present invention.

Referring to FIG. 12, the OLED includes first electrodes 43 formed on a surface of a transparent substrate 41, an organic light emitting layer 45 formed on the first electrodes 43, and second electrodes 47 formed on the organic light emitting layer 45. The first electrode 43 and second electrode 47 may be formed into a matrix type configuration. A housing 49 may be formed to cover at least the organic light emitting layer 45. The housing 49 may be secured with an epoxy molding compound 48.

In the OLED structured as in the above, a porous heat transfer sheet 44 may be arranged adjacent to a rear surface of the housing 49. Accordingly, heat generated within the OLED may be efficiently transmitted to outside the housing 49.

FIG. 13 shows a schematic view of a field emission display having a heat transfer sheet including a plurality of pores according to yet another exemplary embodiment of the present invention.

Referring to FIG. 13, the FED includes a front substrate 51 and a rear substrate 52 arranged opposing each other. Cathode electrodes 53 are formed on the rear substrate 52 and an insulation layer 54 is formed covering the cathode electrodes 53. Gate electrodes 55 are formed on the insulation layer intersecting the cathode electrodes 53. Emitters 57 are formed in pixel regions where the cathode electrodes 53 and the gate electrodes 55 intersect. The emitters 57 emit electrons according to signals applied to the cathode electrodes 53 and the gate electrodes 55. An anode electrode 58 is formed on a surface of the front substrate 51 opposing the rear substrate 52. Electrons emitted from the emitters 57 strike the phosphor films 59 to create predetermined images.

In the FED structured as described above, a porous heat transfer sheet 60 is arranged on an outer surface of the rear substrate 52 such that heat generated in the space between the front substrate 51 and the rear substrate 52 may be efficiently dissipated out of the FED.

In the plasma display devices of the present invention described above, a porous heat transfer sheet having a plurality of pores may be arranged to be adjacent to the display panel. The display panel is the heat source in the plasma display device. As a result, the actual area of contact between the display panel and the heat transfer sheet is increased such that heat is quickly diffused and emitted from the display panel.

The porous heat transfer sheet has a large unit volume contact surface. Also, as a result of its open cell-type structure, air is easily passed through the porous heat transfer sheet via the interconnected pores. Heat generated by the display panel is dispersed by conduction and/or convection improving heat discharge efficiency.

Additionally, the porous heat transfer sheet has shock-absorbing properties. Therefore, the porous heat transfer sheet may reduce external vibrations and shocks, thereby protecting the display panel. Moreover, discharge noise generated by the display panel may be converted to heat energy in the pores, thereby reducing the overall noise of the plasma display device.

[00100] Furthermore, electromagnetic waves generated during operation may be absorbed in a display panel and grounded through a chassis base, preventing the transmission of the electro-magnetic (EM) waves to a circuit.

**[00101]** In addition, by forming the porous heat transfer sheet using a material having anisotropic thermal conductivity, bright image stickings may be significantly reduced.

A ceramic or teflon thin film layer may be formed on the surface of the PDP adjacent to the porous heat transfer sheet improving resistance to wear, thermal conductivity, and insulation properties of the display panel.

Also, a thin metal plate may be arranged between the display panel and the porous heat transfer sheet to prevent wear and/or scratching of the display panels surface during assembly.

By arranging the porous heat transfer sheet adjacent to the panel also in LCDs, OLEDs, FEDs, and other such flat panel displays, heat generated by the display panels is efficiently dispersed and emitted.

Finally, since mounting and removal of the heat transfer sheet of the present invention is easy, reuse of the heat transfer sheet during manufacture and repair is possible.

Although embodiments of the present invention have been described in detail hereinabove in connection with certain exemplary embodiments, it should be understood that the invention is not limited to the disclosed exemplary embodiments, but on the contrary is intended to cover various modifications and/or equivalent arrangements included within the spirit and scope of the present invention as defined in the appended claims.

## Claims

1. A display apparatus, comprising:
a display panel; and
a heat transfer sheet arranged adjacent to a surface of the display panel,
wherein the heat transfer sheet includes a plurality of pores.

2. The display apparatus of claim 1, wherein the plurality of pores include an open cell-type structure interconnecting at least a portion of the plurality of pores.

3. The display apparatus of claim 1, wherein the plurality of pores include a closed cell-type structure in which at least a portion of the plurality of pores are not interconnected with each other.

4. The display apparatus of claim 1, wherein the plurality of pores formed in the heat transfer sheet are in a range from between about 5 to about 80 pores per inch (ppi).

5. The display apparatus of claim 1, wherein a porosity of the porous heat transfer sheet is between about 35 % to about 95 %.

6. The display apparatus of claim 1, wherein the heat transfer sheet comprises a metal material.

7. The display apparatus of claim 1, wherein the heat transfer sheet comprises a material selected from a group consisting of aluminum, copper, silver, gold, steel, nickel, stainless steel, and brass.

8. The display apparatus of claim 1, wherein the heat transfer sheet has a greater thermal conductivity in a substantially x-y planar direction than in a direction of a z direction of the heat transfer sheet.

9. The display apparatus of claim 8, wherein the thermal conductivity in the x-y planar direction of the heat transfer sheet is about five times or more than the thermal conductivity in the z direction of the porous heat transfer sheet.

10. The display apparatus of claim 8, wherein the heat transfer sheet is made of a material selected from a group consisting of carbon, graphite, carbon nanotubes, and carbon fiber.

11. The display apparatus of claim 1, further comprising a thin film formed on a surface of the display panel opposing the heat transfer sheet,
wherein the thin film has a greater thermal conductivity than the display panel.

12. The display apparatus of claim 11, wherein the thin film is made of one of ceramic and teflon.

13. The display apparatus of claim 1, further comprising a thin metal plate arranged between the display panel and the heat transfer sheet.

14. The display apparatus of claim 13, wherein the thin metal plate comprises at least one of aluminum and copper.

15. The display apparatus of claim 1, wherein the display panel is a flat panel display.

16. The display apparatus of claim 1, wherein the display panel is a plasma display panel.

17. The display apparatus of claim 1, wherein the display panel is a liquid crystal display.

18. The display apparatus of claim 1, wherein the display panel is an organic light emitting display.

19. The display apparatus of claim 1, wherein the display panel is a field emission display.

20. A display apparatus, comprising:
a display panel; and
a heat transfer sheet arranged adjacent to a surface of the display panel,
wherein the heat transfer sheet includes a plurality of fibrous elements.

21. The display apparatus of claim 20, wherein the fibrous elements comprise metal.

22. The display apparatus of claim 20, wherein the fibrous elements comprise a material selected from a group consisting of carbon, graphite, carbon nanotubes, and carbon fiber.

23. The display apparatus of claim 20, further comprising a thin film formed on a surface of the display panel, wherein the thin film has a higher thermal conductivity than the display panel.

24. The display apparatus of claim 20, further comprising a metal plate arranged between the display panel and the heat transfer sheet.

25. A display apparatus, comprising:
a display panel; and
a heat transfer sheet arranged adjacent a surface of the display panel,
wherein the heat transfer sheet includes a plurality of flakes.

26. The display apparatus of claim 25, wherein the flakes are made of metal.

27. The display apparatus of claim 25, wherein the flakes comprise a material selected from a group consisting of carbon, graphite, carbon nanotubes, and carbon fiber.

28. The display apparatus of claim 25, further comprising a film formed on a surface of the display panel, wherein the film has a higher thermal conductivity than the display panel.

29. The display apparatus of claim 25, further comprising a metal plate arranged between the display panel and the heat transfer sheet.

30. A display apparatus, comprising:
a plasma display panel;
a chassis base mounted substantially in parallel with the plasma display panel; and
a heat transfer sheet arranged between the plasma display panel and the chassis base,
wherein the heat transfer sheet comprises a plurality of pores.

31. The display apparatus of claim 30, wherein the heat transfer sheet is adhered to a surface of the plasma display panel opposing the chassis base.

32. The display apparatus of claim 30, wherein the plurality of pores have an open cell-type structure in which at least a portion of the pores are interconnected.

33. The display apparatus of claim 30, wherein the plurality of pores comprise a closed cell-type structure,
wherein at least a portion of the plurality of pores are not in communication with each other.

34. The display apparatus of claim 30, wherein the plurality of pores formed in the heat transfer sheet range from between about 5 to about 80 pores per inch (ppi).

35. The display apparatus of claim 30, wherein a porosity of the heat transfer sheet is in a range from between about 35% to about 95%.

36. The display apparatus of claim 30, wherein the heat transfer sheet comprises a metal material.

37. The display apparatus of claim 36, wherein the heat transfer sheet comprises a material selected from a group consisting of aluminum, copper, silver, gold, steel, nickel, stainless steel, and brass.

38. The display apparatus of claim 30, wherein the heat transfer sheet has a thermal conductivity in substantially a x-y planar direction that is greater than the a thermal conductivity in a different direction.

39. The display apparatus of claim 38, wherein the thermal conductivity in the substantially x-y planar direction is five times or more than the thermal conductivity in a z direction of the heat transfer sheet.

40. The display apparatus of claim 38, wherein the porous heat transfer sheet comprises a material selected from a group consisting of carbon, graphite, carbon nanotubes, and carbon fiber.

41. The display apparatus of claim 30, further comprising a film formed on a surface of the plasma display panel opposing the porous heat transfer sheet,
wherein the film has a greater thermal conductivity than the display panel.

42. The display apparatus of claim 41, wherein the film comprises at least one of ceramic and teflon.

43. The display apparatus of claim 30, further comprising a metal plate arranged between the plasma display panel and the heat transfer sheet.

44. The display apparatus of claim 43, wherein the metal plate comprises at least one of aluminum and copper.

45. The display apparatus of claim 30, wherein chassis base comprises a depression formed on a side of the chassis base opposing the plasma display panel and at least a portion of the heat transfer sheet is arranged within the depression.
